(19) Europäisches Patentamt
European Patent Office
Office européen des brevets

(11) **EP 1 333 581 B1**

## (12) EUROPÄISCHE PATENTSCHRIFT

(45) Veröffentlichungstag und Bekanntmachung des Hinweises auf die Patenterteilung:
**08.04.2015 Patentblatt 2015/15**

(51) Int Cl.:
*H03K 5/159* (2006.01)       *H03K 7/06* (2006.01)
*H04B 15/04* (2006.01)       *H03L 7/081* (2006.01)

(21) Anmeldenummer: **02002307.3**

(22) Anmeldetag: **30.01.2002**

(54) **Taktsignalerzeugungseinrichtung**

Clock signal generator

Générateur de signal d'horloge

(84) Benannte Vertragsstaaten:
**DE FR IT**

(43) Veröffentlichungstag der Anmeldung:
**06.08.2003 Patentblatt 2003/32**

(73) Patentinhaber: **Infineon Technologies AG**
**85579 Neubiberg (DE)**

(72) Erfinder:
• **Steinecke, Thomas**
  **85457 Wörth (DE)**
• **Hesidenz, Dirk**
  **82024 Taufkirchen (DE)**

(74) Vertreter: **Repkow, Ines et al**
**Jannig & Repkow**
**Patentanwälte**
**Klausenberg 20**
**86199 Augsburg (DE)**

(56) Entgegenhaltungen:
**EP-A- 0 319 851     US-A- 6 160 456**

• **PATENT ABSTRACTS OF JAPAN vol. 2000, no. 07, 29. September 2000 (2000-09-29) -& JP 2000 101424 A (SONY CORP), 7. April 2000 (2000-04-07)**

**Beschreibung**

Die vorliegende Erfindung betrifft eine Vorrichtung gemäß dem Oberbegriff des Patentanspruchs 1, d.h. eine Taktsignalerzeugungseinrichtung mit einem Oszillator und einer diesem nachgeschalteten PLL.

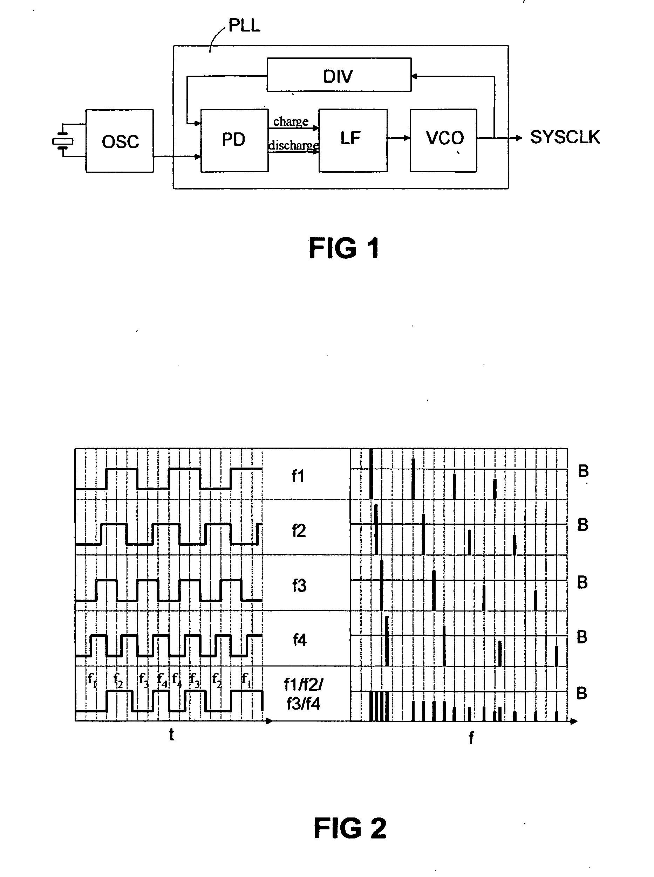

Eine solche Taktsignalerzeugungseinrichtung ist in Figur 1 veranschaulicht.

Dabei sind der Oszillator mit dem Bezugszeichen OSC, und die PLL (phase locked loop) mit dem Bezugszeichen PLL bezeichnet. Die PLL enthält einen Phasenvergleicher bzw Phasendetektor PD, ein Loop Filter LF, einen spannungsgesteuerten Oszillator VCO und einen Frequenzteiler DIV, welche wie in der Figur 1 gezeigt verschaltet sind.

Eine PLL dient im allgemeinen dazu, ein Taktsignal zu erzeugen, dessen Frequenz sich von der Frequenz des vom Oszillators OSC ausgegebenen Signals unterscheidet, genauer gesagt um einen bestimmten Faktor größer ist.

Das von der PLL ausgegebene Taktsignal wird vom spannungsgesteuerten Oszillator VCO erzeugt. D.h. das Ausgangssignal des spannungsgesteuerten Oszillators VCO ist zugleich das Ausgangssignal der in der Figur 1 gezeigten Anordnung. Das Ausgangssignal des spannungsgesteuerten Oszillators VCO wird darüber hinaus dem Frequenzteiler DIV zugeführt. Der Frequenzteiler DIV erzeugt ein Signal, dessen Frequenz um einen bestimmten Faktor kleiner ist als die Frequenz des ihm zugeführten Signals. Der Faktor ist so gewählt, daß die Frequenz des Ausgangssignals des Frequenzteilers DIV dann, wenn die Frequenz des vom spannungsgesteuerten Oszillator VCO erzeugten Signals die angestrebte Soll-Frequenz ist, genau der Frequenz des vom Oszillator OSC ausgegebenen Signals entspricht.

Das Ausgangssignal des Frequenzteilers DIV wird dem Phasenvergleicher PD zugeführt. Dem Phasenvergleicher PD wird zusätzlich das vom Oszillator OSC ausgegebene Signal zugeführt. Der Phasenvergleicher PD vergleicht die Phasen, genauer gesagt die Lage der Flanken der ihm zugeführten Signale und gibt von der Phasendifferenz abhängende Signale charge und discharge aus. Diese Signale werden dem Loop Filter zugeführt, welcher diese in ein Ansteuersignal für den spannungsgesteuerten Oszillator VCO umsetzt. Die Umsetzung erfolgt derart, daß der spannungsgesteuerte Oszillator VCO veranlaßt wird, seine momentane Frequenz beizubehalten, wenn die Phasendifferenz gleich null ist, und die Frequenz zu verändern, wenn die Phasendifferenz ungleich null ist.

Wenn die Phasendifferenz gleich null ist, spricht man davon, daß die PLL eingerastet ist. Die PLL läuft von da an stabil, da Abweichungen der Frequenz des vom spannungsgesteuerten Oszillator VCO ausgegebenen Signals von der Soll-Frequenz aufgrund der daraus resultierenden relativen Phasenverschiebung zwischen den dem Phasenvergleicher zugeführten Signalen sofort ausgeregelt werden.

Obgleich die Frequenz des von der Anordnung gemäß Figur 1 erzeugten Taktsignals im allgemeinen stets genau die Soll-Frequenz ist, kann die Verwendung dieses Taktsignals in der Praxis zu Problemen führen. Die elektrischen Schaltungen, die unter Verwendung eines solchen Taktsignals arbeiten, erzeugen nämlich massive elektromagnetische Abstrahlungen. Besonders unangenehm ist, daß sich hierbei bei einigen wenigen Frequenzen besonders starke Abstrahlungen ergeben. Die Frequenzspektren der elektromagnetischen Abstrahlungen zeigen klar erkennbar die Taktharmonischen als Hauptstörfrequenzen.

Zwar werden sich elektromagnetische Abstrahlungen nie ganz verhindern lassen, doch wäre es in vielen Fällen günstiger, wenn sich die Störungen wenigstens etwas gleichmäßiger über einen größeren Frequenzbereich verteilen würden.

Dies läßt sich beispielsweise dadurch erreichen, daß die Frequenz des von der Taktsignalerzeugungseinrichtung erzeugten Taktsignals variiert wird, also ein frequenzmoduliertes Taktsignal erzeugt wird.

Die dadurch erzielbaren Effekte sind in Figur 2 veranschaulicht.

In der Figur 2 ist auf der linken Seite der Verlauf verschiedener Taktsignale dargestellt, und jeweils rechts daneben das Frequenzspektrum der betreffenden Taktsignale.

Es sind die Verhältnisse für fünf verschiedene Taktsignale dargestellt, und zwar

- ganz oben für ein Taktsignal mit einer konstanten Frequenz f1,

- darunter für ein Taktsignal mit einer konstanten Frequenz f2,

- darunter für ein Taktsignal mit einer konstanten Frequenz f3,

- darunter für ein Taktsignal mit einer konstanten Frequenz f4, und

- ganz unten für ein Taktsignal mit zwischen f1 und f4 variierender Frequenz.

Wie aus der Beschriftung des letztgenannten Taktsignals, d.h. des Taktsignals mit variierender Frequenz ersichtlich ist, setzt sich dieses aus Perioden bzw. Periodenteilen der Taktsignale mit den konstanten Frequenzen f1 bis f4 zusammen, ist also das Ergebnis einer treppenförmigen Modulation.

Wie aus der Darstellung der Frequenzspektren in Figur 2 ersichtlich ist, weist das Frequenzspektrum des Taktsignals mit variierender Frequenz den geringsten Maximalwert auf; dieser Maximalwert ist durch eine Bezugslinie B veranschaulicht. Die Maximalwerte der Frequenzspektren für die Taktsignale mit konstanter Frequenz f1 bzw. f2 bzw. f3 bzw. f4 sind demgegenüber erheblich größer. Zwar treten beim Taktsignal mit variierender Frequenz bei einer größeren Anzahl von Frequenzen Extremwerte auf, doch ist eine Verteilung der Energie auf mehrere Frequenzen bzw. einen größeren Frequenzbereich im allgemeinen problemlos tolerierbar. Der Vollständigkeit halber sei in diesem Zusammenhang angemerkt, daß sich die Energie für ein stetiges Modulationssignal über einen Frequenzbereich verteilt, der proportional zum Modulationshub ist.

Die durch ein Taktsignal mit variierender Frequenz erzielbaren Effekte und Möglichkeiten zur Erzeugung eines Taktsignals mit variierender Frequenz sind beispielsweise aus

[1] EP 0 655 829 A1
[2] EP 0 739 089 A2
[3] WO 00/21237 A1
[4] Keith B. Hardin et al: Spread Spectrum Clock Generation for the Reduction of Radiated Emissions, 1994 IEEE International Symposium On Electromagnetic Compatibility
[5] Keith B. Hardin et al: A Study of the Interference Potential of Spread Spectrum Clock Generation Techniques, 1995 IEEE International Symposium On Electromagnetic Compatibility
[6] Keith B. Hardin et al: Design Considerations of Phase-Locked Loop Systems for Spread Spectrum Clock Generation Compatibility, 1997 IEEE International Symposium On Electromagnetic Compatibility

und aus JP 2000101424 A

bekannt.

Die Verwendung von Taktsignalen mit variierender Frequenz wird mit dem Fachbegriff "Spread Spectrum Clocking" bezeichnet; Taktsignalerzeugungseinrichtungen, die Taktsignale mit variierender Frequenz erzeugen, werden mit dem Fachbegriff "Spread-Spectrum-Oszillatoren" bezeichnet.

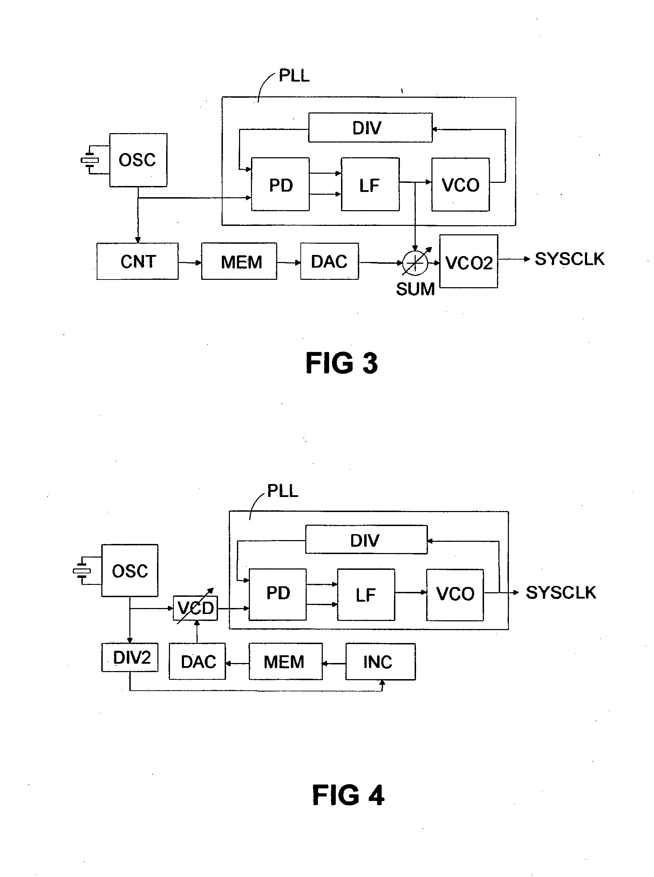

Spread-Spectrum-Oszillatoren sind bereits bekannt. Ein bekannter Spread-Spectrum-Oszillator ist in Figur 3 gezeigt.

Der in der Figur 3 gezeigte Spread-Spectrum-Oszillator enthält einen Oszillator OSC, eine PLL PLL, einen Zähler CNT, eine beispielsweise durch ein ROM gebildete Speichereinrichtung MEM, einen D/A-Wandler DAC, ein Summationsglied SUM, und einen zweiten spannungsgesteuerten Oszillator VCO2.

Der Oszillator OSC und die PLL PLL sind der Oszillator OSC und die PLL der in der Figur 1 gezeigten Taktsignalerzeugungseinrichtung. Bezüglich weiterer Einzelheiten hierzu wird auf die auf die Figur 1 bezugnehmenden Erläuterungen verwiesen.

Der Zähler CNT erhält als Eingangssignal das vom Oszillator OSC ausgegebene Taktsignal und gibt den Zählstand an den Speicher MEM aus. Der Speicher MEM verwendet den vom Zähler CNT ausgegebenen Zählstand als Adresse, und gibt die unter dieser Adresse gespeicherten Daten an den D/A-Wandler DAC aus. Der D/A-Wandler unterzieht die ihm zugeführten Daten einer D/A-Wandlung und gibt das Ergebnis dieser D/A-Wandlung an das Summationsglied SUM aus. Dem Summationsglied SUM wird darüber hinaus auch das Ausgangssignal des Loop Filter LF der PLL zugeführt. Das Summationsglied summiert die ihm zugeführten Signale und gibt das daraus resultierende Signal als Steuersignal an den zweiten spannungsgesteuerten Oszillator VCO2 aus.

Das vom Spread-Spectrum-Oszillator gemäß Figur 3 erzeugte Taktsignal ist das vom zweiten spannungsgesteuerten Oszillator VCO2 ausgegebene Taktsignal. Dieser zweite spannungsgesteuerte Oszillator VCO2 hat dieselbe Grundfrequenz wie der spannungsgesteuerte Oszillator VCO der PLL, und wird wie dieser auch unter Verwendung des Ausgangssignals des Loop Filter LF angesteuert. Die den zweiten spannungsgesteuerten Oszillator VCO2 steuernde Steuerspannung hängt darüber hinaus aber auch noch von einem durch den Zähler CNT, die Speichereinrichtung MEM, und den D/A-Wandler DAC gebildeten Offset ab; die den zweiten spannungsgesteuerten Oszillator VCO2 steuernde Steuerspannung ist das Ausgangssignal des Summationsgliedes SUM. Die Summation des genannten Offset zum Ausgangssignal des Loop Filter LF hat zur Folge, daß das vom zweiten spannungsgesteuerten Oszillator VCO2 ausgegebene Taktsignal gegenüber dem vom spannungsgesteuerten Oszillator VCO ausgegebenen Taktsignal gezielt verstimmt ist.

Genauer gesagt wird durch den Offset die Ausgabe eines frequenzmodulierten Signals aus dem zweiten spannungsgesteuerten Oszillator VCO2 bewirkt, wobei durch den Offset sowohl die Modulationsfrequenz als auch der Modulationshub vorgegeben werden.

Die Modulationsfrequenz wird durch den Zähler CNT bestimmt. Durch den Zähler CNT wird, wie vorstehend bereits erwähnt wurde, der Speicher MEM adressiert, in welchem in diskreter Form die Modulationskurvenform gespeichert ist.

Der Modulationshub kann sowohl durch die Wahl des Wertebereichs im Speicher MEM als auch durch den Signalhub des Digital-Analog-Wandlers DAC bestimmt werden. Realistische Werte liegen zwischen 0,1% und 1% des Systemtaktes.

Die Ermittlung der optimalen Modulationskurvenform ist in [4] beschrieben.

Der beschriebene Spread-Spectrum-Oszillator weist den Nachteil auf, daß dessen Realisierung relativ aufwendig ist, und daß zur praktischen Realisierung in einer integrierten Schaltung relativ viel Fläche benötigt wird, so daß eine einen solchen Spread-Spectrum-Oszillator enthaltende integrierte Schaltung groß und teuer wird.

Der vorliegenden Erfindung liegt daher die Aufgabe zugrunde, einen einfacher und kleiner realisierbaren Spread-Spectrum-Oszillator zu schaffen.

Diese Aufgabe wird erfindungsgemäß durch die in Patentanspruch 1 beanspruchte Taktsignalerzeugungseinrichtung gelöst.

Die erfindungsgemäße Taktsignalerzeugungseinrichtung zeichnet sich dadurch aus, daß zwischen dem Oszillator und der PLL eine Phasenverschiebungseinrichtung vorgesehen ist, welche die Flanken des vom Oszillator ausgegebenen Signals in zeitlich variierbarem Umfang verschieben kann, und das daraus resultierende Signal der PLL als Eingangssignal zuführt.

Da die beanspruchte Taktsignalerzeugungseinrichtung keinen zweiten spannungsgesteuerten Oszillator enthält, sondern "nur" eine Phasenverschiebungseinrichtung mit steuerbarer Phasenverschiebung, ist sie einfacher und kleiner realisierbar als herkömmliche Spread-Spectrum-Oszillatoren.

Vorteilhafte Weiterbildungen der Erfindung sind den Unteransprüchen, der folgenden Beschreibung, und den Figuren entnehmbar.

Die Erfindung wird nachfolgend anhand eines Ausführungsbeispiels unter Bezugnahme auf die Figuren näher erläutert. Es zeigen

Figur 1    eine herkömmliche Taktsignalerzeugungseinrichtung zur Erzeugung eines Taktsignals mit konstanter Frequenz,

Figur 2    den zeitlichen Verlauf und das Frequenzspektrum von verschiedenen Taktsignalen,

Figur 3    eine herkömmliche Taktsignalerzeugungseinrichtung zur Erzeugung eines Taktsignals mit variierender Frequenz,

Figur 4    die im folgenden näher beschriebene Taktsignalerzeugungseinrichtung,

Figur 5    eine Darstellung zur Veranschaulichung der Phasenverschiebung, die eine Phasenverschiebungseinrichtung der Taktsignalerzeugungseinrichtung gemäß Figur 4 durchführen muß, um ein Taktsignal mit einer gegenüber dem ihr zugeführten Taktsignal konstant reduzierten Frequenz zu erzeugen, und

Figur 6    eine Darstellung zur Veranschaulichung der Phasenverschiebung, die die Phasenverschiebungseinrichtung durchführen muß, damit die Taktsignalerzeugungseinrichtung ein Taktsignal mit variierender Frequenz erzeugt.

Die im folgenden beschriebene Taktsignalerzeugungseinrichtung ist mit Ausnahme des Oszillators Bestandteil einer programmgesteuerten Einheit wie beispielsweise eines Mikroprozessors, eines Mikrocontrollers oder eines Signalprozessors. Es sei jedoch bereits an dieser Stelle darauf hingewiesen, daß die beschriebene Taktsignalerzeugungseinrichtung auch Bestandteil eines beliebigen anderen Bausteins sein kann, und auch ein eigener Baustein ohne weitere Komponenten sein kann. Die Taktsignalerzeugungseinrichtung kann auch als diskrete Schaltung aufgebaut sein.

Die Taktsignalerzeugungseinrichtung kann sowohl die diese enthaltende programmgesteuerte Einheit als auch andere Systemkomponenten mit dem von ihr erzeugten Taktsignal versorgen; die programmgesteuerte Einheit enthält vorzugsweise einen Ausgangsanschluß, über welchen das von der Taktsignalerzeugungseinrichtung erzeugte Taktsignal aus der programmgesteuerten Einheit ausgegeben werden kann.

Die hier vorgestellte Taktsignalerzeugungseinrichtung ist ein Spread-Spectrum-Oszillator mit einem vereinfachten Aufbau. Der prinzipielle Aufbau ist in Figur 4 gezeigt.

Die in der Figur 4 gezeigte Taktsignalerzeugungseinrichtung enthält einen Oszillator OSC, eine PLL PLL, eine im betrachteten Beispiel durch ein spannungsgesteuertes Verzögerungsglied VCD gebildete Phasenverschiebungseinrichtung mit steuerbarer Phasenverschiebung, einen zweiten Frequenzteiler DIV2, eine Inkrementierungseinrichtung INC, einen vorzugsweise durch einen nichtflüchtigen Speicher wie beispielsweise ein ROM gebildeten Speicher MEM, und einen D/A-Wandler DAC.

Der Oszillator OSC und die PLL PLL sind der Oszillator OSC und die PLL der in der Figur 1 gezeigten Taktsignalerzeugungseinrichtung oder diesen entsprechende Komponenten. Bezüglich weiterer Einzelheiten hierzu wird auf die auf die Figur 1 bezugnehmenden Erläuterungen verwiesen.

Das spannungsgesteuerte Verzögerungsglied VCD ist zwischen dem Oszillator OSC und der PLL angeordnet. D.h., das vom Oszillator OSC erzeugte Taktsignal wird anders als bei den in den Figuren 1 und 3 gezeigten Taktsignalerzeugungseinrichtungen der PLL nicht direkt, sondern über das spannungsgesteuerte Verzögerungsglied VCD zugeführt. Das spannungsgesteuerte Verzögerungsglied VCD wird durch das Ausgangssignal des D/A-Wandlers DAC gesteuert. Das vom D/A-Wandler DAC ausgegebene Signal ist das Ergebnis der D/A-Wandlung von vom Speicher MEM ausgegebenen Daten. Der Speicher MEM wird durch das Ausgangssignal des als Adreßgenerierungseinrichtung wirkenden Inkrementierers INC adressiert. Der Inkrementierer INC wird durch das Ausgangssignal des zweiten Frequenzteilers DIV2 angesteuert. Der zweite Frequenzteiler DIV2 erhält als Eingangssignal das vom Oszillator OSC ausgegebene Taktsignal und erzeugt daraus ein Taktsignal, dessen Frequenz um einen bestimmten Faktor kleiner ist als die Frequenz des Ausgangssignal des Oszillators OSC.

Im Speicher MEM sind in digitaler Form die Steuersignale gespeichert, unter Verwendung welcher das spannungsgesteuerte Verzögerungsglied VCD angesteuert werden muß, um das diesem zugeführte Signal, genauer gesagt dessen Flanken wunschgemäß zu verzögern. Durch den zweiten Frequenzteiler DIV2 und die Inkrementierungseinrichtung INC wird dafür gesorgt, daß der Speicher MEM zum gewünschten Zeitpunkt das Steuersignal ausgibt, unter Verwendung dessen das spannungsgesteuerte Verzögerungsglied VCD angesteuert werden muß, damit es die jeweils gewünschte Verzögerung durchführt.

Das spannungsgesteuerte Verzögerungsglied VCD wird so angesteuert, daß das von ihm ausgegebene, der PLL zugeführte Signal die PLL dazu veranlaßt, ein Taktsignal mit variierender Frequenz zu erzeugen. Dies geschieht dadurch, daß das spannungsgesteuerte Verzögerungsglied VCD die steigenden und fallenden Flanken des vom Oszillator OSC ausgegebenen Taktsignals so verzögert, daß der PLL ein Taktsignal zugeführt wird, dessen Frequenz scheinbar variiert. Die Frequenz des vom spannungsgesteuerten Verzögerungsglied VCD ausgegebenen Taktsignals verändert sich aber in Wirklichkeit nicht; der PLL wird durch eine geschickte Phasenverschiebung in dem ihr vom spannungsgesteuerten Verzögerungsglied zugeführten Taktsignal nur eine Frequenzvariierung vorgetäuscht. Es ist nicht notwendig, der PLL ein Taktsignal mit variierender Frequenz zuzuführen, um die PLL zur Ausgabe eines Taktsignals mit variierender Frequenz zu veranlassen, denn die Nachregelung der Frequenz des von der PLL ausgegebenen Taktsignals SYSCLK erfolgt ja nicht abhängig von der Frequenzdifferenz, sondern abhängig von der Phasendifferenz der dem Phasenvergleicher PD zugeführten Signale.

Im betrachteten Beispiel wird durch das spannungsgesteuerte Verzögerungsglied VCD jede Flanke des vom Oszillator OSC ausgegebenen Taktsignals um eine gewisse Zeit mehr oder weniger verzögert als die vorhergehende Flanke. Dabei muß beachtet werden, daß eine Taktflanke des vom Oszillator ausgegebenen Taktsignals nicht so weit verzögert werden darf, daß sie von der Taktflanke des zum Phasendetektor PD rückgekoppelten Ausgangssignals des spannungsgesteuerten Oszillators VCO überholt wird. Im Normalfall ist die maximal zulässige Zeitdifferenz zwischen einer Flanke des vom Oszillator ausgegebenen Taktsignals und dem vom spannungsgesteuerten Oszillator VCO ausgegebenen Signal gleich ungefähr eine Taktperiode. Wird vom spannungsgesteuerten Verzögerungsglied VCD nur eine Taktflanke (steigend oder fallend) verzögert, reduziert sich die zulässige Zeitdifferenz auf eine halbe Taktperiode.

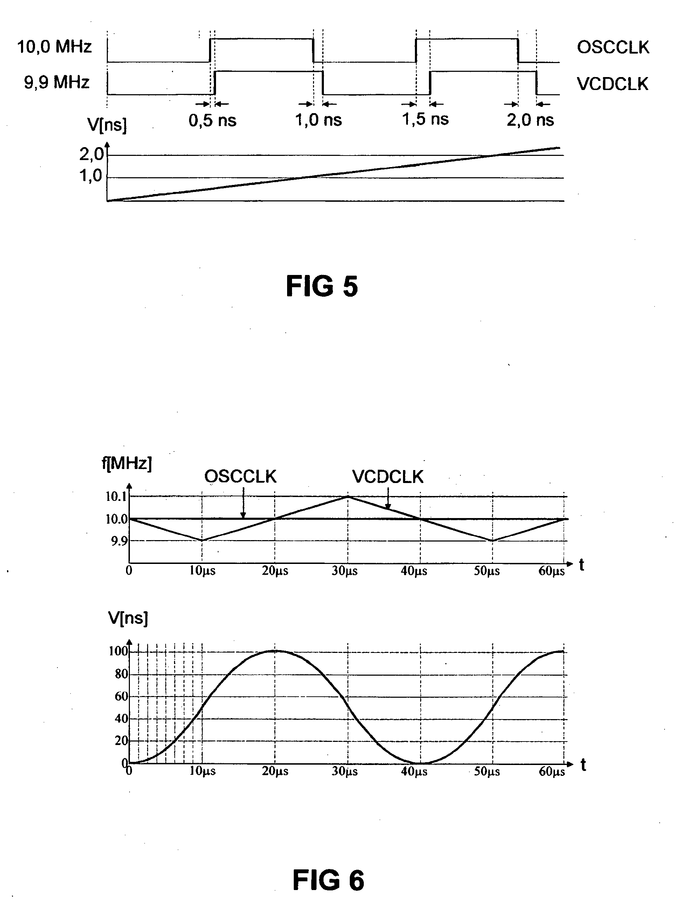

Durch das spannungsgesteuerte Verzögerungsglied VCD kann auch für eine gewisse (kurze) Zeit ein Taktsignal erzeugt werden, dessen Frequenz tatsächlich (nicht nur scheinbar) konstant um einen bestimmten Betrag größer oder kleiner ist als die Frequenz des ihm zugeführten Oszillatorsignals. Bevor näher erläutert wird, wie vorgegangen werden muß, damit das spannungsgesteuerte Verzögerungsglied VCD ein Taktsignal mit variierender Frequenz ausgibt, wird zunächst unter Bezugnahme auf Figur 5 dieser einfachere Fall erläutert.

In Figur 5 ist beispielhaft veranschaulicht, wie die Flanken eines Oszillatorsignals mit einer Frequenz von 10 MHz durch das spannungsgesteuerte Verzögerungsglied VCD zu verzögern sind, damit dieses ein Signal mit einer konstanten Frequenz von 9,9 MHz ausgibt.

In der obersten Darstellung ist das Oszillatorsignal OSCCLK dargestellt. Darunter ist das vom spannungsgesteuerten Verzögerungsglied VCD ausgegebene Taktsignal VCDCLK dargestellt, und ganz unten ist der Verlauf der Verzögerung V eingezeichnet, mit welcher das spannungsgesteuerte Verzögerungsglied VCD die im Oszillatorsignal auftretenden Flanken jeweils zu verzögern hat.

Wie aus der Figur 5 ersichtlich ist, wird die erste steigende Flanke des Oszillatorsignals um 0,5 ns verzögert, die darauf folgende fallende Flanke um 0,5 ns mehr, also um 1,0 ns verzögert, die darauf folgende steigende Flanke abermals um 0,5 ns mehr, also um 1,5 ns verzögert, die darauf folgende fallende Flanke abermals um 0,5 ns mehr, also um 2,0 ns verzögert, usw.

Damit ist jede Taktperiode um 1 ns kürzer als die jeweils vorhergehende Taktperiode. Da die Periodendauer eines Signals mit einer Frequenz von 10 MHz 100 ns beträgt, treffen nach 100 Taktperioden die Taktflanken des Oszillatorsignals und des vom spannungsgesteuerten Verzögerungsglied VCD erzeugten Taktsignals aufeinander. Die Phasenbeziehung stimmt dann nicht mehr und das spannungsgesteuerte Verzögerungsglied VCD liefert eine falsche Information am Ausgang.

Bei einem Spread-Spectrum-Oszillators muß das spannungsgesteuerten Verzögerungsglied VCD - anders als bei dem in der Figur 5 veranschaulichten Beispiel - kein Taktsignal erzeugen, dessen Frequenz dauerhaft um einen bestimmten konstanten Betrag von der Frequenz des Oszillatorsignals abweicht, sondern ein Taktsignal, dessen Frequenz variiert, genauer gesagt um die Frequenz des Oszillatorsignals wandert.

Ein Beispiel hierfür ist in Figur 6 veranschaulicht.

Das in der Figur 6 gezeigte Beispiel veranschaulicht eine dreieckförmige Frequenzmodulation des Oszillatorsignals OSCCLK, dessen Frequenz wiederum 10 MHz betragen möge. Im betrachteten Beispiel beträgt der Modulationshub 100 kHz, wodurch die Frequenz des vom spannungsgesteuerten Verzögerungsglied VCD erzeugten Taktsignals VCDCLK zwischen 9,9 MHz und 10,1 MHz pendelt. Die Modulationsfrequenz wurde zu 25 kHz gewählt, was einer Periodendauer von 40 $\mu$s entspricht. Somit muß die Frequenz des vom spannungsgesteuerten Verzögerungsglied VCD erzeugten Taktsignals innerhalb von 10$\mu$s von 10,0 MHz auf 9,9 MHz absinken, anschließend innerhalb 20 $\mu$s wieder von 9,9 MHz auf 10,1 MHz ansteigen, danach in weiteren 20 $\mu$s wieder von 10,1 MHz auf 9,9MHz absinken, und so weiter. Der zeitliche Verlauf der Frequenz dieses Taktsignals ist im oberen Diagramm der Figur 6 veranschaulicht.

Die Zeiten, um welche das spannungsgesteuerte Verzögerungsglied VCD die Flanken des Oszillatorsignals verzögern muß, ergeben sich aus folgenden Überlegungen:

In 10 $\mu$s sind 100 Taktperioden des 10 MHz-Oszillatortaktes enthalten.

Um innerhalb dieser 10 $\mu$s einen linearen Frequenzabfall von 100kHz zu erreichen, muß jeweils pro Taktperiode (100ns) zu der zuletzt verwendeten Verzögerungszeit eine Verzögerung hinzugefügt werden, die gleich der Summe der zuletzt hinzugefügten Verzögerung plus 10 ps ist. Somit beträgt die erforderliche Gesamtverzögerung des spannungsgesteuerten Verzögerungsgliedes VCD:

nach 100ns: 10ps,
nach 200ns: 30ps,
nach 300ns: 60ps,
nach 400ns: 100ps,

und so weiter.

Der zeitliche Verlauf der Verzögerungszeit VCD, um welche das spannungsgesteuerte Verzögerungsglied die im Oszillatorsignal auftretenden Flanken verzögern muß, um den im oberen Diagramm der Figur 6 gezeigten Frequenzverlauf zu erreichen, ist im unteren Diagramm der Figur 6 veranschaulicht.

Allgemein gilt für die absolut einzustellende Verzögerung $t_d$ nach n Taktperioden bei einer Periodenänderung $\Delta P$, wobei $\Delta P$ der Unterschied der Periodendauer zwischen der Oszillatorfrequenz $f_{osc}$ und der maximalen Frequenz des vom spannungsgesteuerten Verzögerungsglied ausgegebenen Signal (Oszillatorfrequenz $f_{osc}$ plus Frequenzhub $f_{hub}$) ist:

$$\Delta P = \frac{1}{f_{osc}} - \frac{1}{f_{osc} - f_{hub}}$$

$$t_d = \Delta P \cdot \sum_{1}^{n} n = \frac{n \cdot (n+1)}{2} \cdot \Delta P$$

Für das in Figur 6 gezeigte Beispiel ($f_{osc}$ = 10,0 MHz; $f_{hub}$ = 100 kHz; n = 100) ergibt sich somit: $\Delta P$ = 10 ps; $t_d$ = 50,5 ns.

Nach dem Umkehrpunkt bei t=10 $\mu$s muß die pro Taktperiode (100 ns) zu addierende Verzögerung wieder sukzessive kleiner werden, damit die resultierende Frequenz zunimmt. Aufgrund der Symmetrie der Modulationskurve muß die Verzögerung pro Taktperiode um 10 ps plus der vorherigen Verminderung reduziert werden, das heißt sukzessive um 10 ps, 20 ps, 30 ps und so weiter. Die absolut im VCD einzustellende zusätzliche Verzögerung nimmt dadurch um 10 ps, 30 ps, 60 ps, 100 ps und so weiter pro Taktperiode (100 ns) ab. Trotzdem wird die Gesamtverzögerung des VCD immer noch größer, allerdings von Taktperiode zu Taktperiode um einen kleiner werdenden Betrag. Damit wird nach weiteren 10 $\mu$s der Wert 0 für die aufzuaddierende Verzögerung erreicht. Anschließend wird die Verzögerung real wieder vermindert.

Mathematisch ausgedrückt, wird eine konstante Frequenzabweichung durch die Aufsummierung der Differenz der Periodendauern von Ausgangs- und Zielfrequenz erreicht. Eine stetige Frequenzänderung erfordert die zusätzliche Aufintegration der jeweiligen Periodendauerdifferenzen zwischen vorheriger und aktueller Periode.

Für den in Abb. 6 gezeigten Fall ergeben sich die in der folgenden Tabelle aufgelisteten Änderungen und Absolutwerte der pro Taktperiode einzustellenden Verzögerungszeiten im spannungsgesteuerten Verzögerungsglied VCD. Die Tabelle deckt eine komplette Periode des Modulationssignals ab, welche mit 40$\mu$s Dauer genau 400 Taktperioden des Oszillatorsignals umfaßt. Der einzustellende Maximalwert für die Verzögerungszeit beträgt 101 ns. Dabei ist zu beachten, daß diese Berechnung für eine Steuerung, jedoch nicht für eine Regelung im Sinne einer PLL angestellt wurden. Durch die Rückkopplung innerhalb der PLL wird ein Ausgleich der Flankenverzögerung angestrebt, der letztendlich zu einer Verminderung der real im VCD einzustellenden Verzögerungszeit führt. Dieser Effekt wurde durch Analogsimulationen der kompletten Schaltung bestätigt.

| Zeit [μs] | Oszillatorsignal-Periode Nr. | $t_d$ Änderung [ps] | $t_d$ absolut [ps] | resultierende Frequenz [MHz] |
|---|---|---|---|---|
| 0 | 0 | 0 | 0 | 10,000 |
| 0,1 | 1 | 10 | 10 | 9,999 |
| 0,2 | 2 | 20 | 30 | 9,998 |
| 0,3 | 3 | 30 | 60 | 9,997 |
| ... | | | | |
| 9,8 | 98 | 980 | 48530 | 9,902 |
| 9,9 | 99 | 990 | 49510 | 9,901 |
| 10,0 | 100 | 1000 | 50500 | 9,900 |
| 10,1 | 101 | 990 | 51490 | 9,901 |
| 10,2 | 102 | 980 | 52470 | 9,902 |
| ... | | | | |
| 19,8 | 198 | 20 | 100970 | 9,998 |
| 19,9 | 199 | 10 | 100990 | 9,999 |
| 20,0 | 200 | 0 | 101000 | 10,000 |
| 20,1 | 201 | -10 | 100990 | 10,001 |
| 20,2 | 202 | -20 | 100970 | 10,002 |
| ... | | | | |
| 29,8 | 298 | -980 | 52470 | 10,098 |
| 29,9 | 299 | -990 | 51490 | 10,099 |
| 30,0 | 300 | -1000 | 50500 | 10,100 |
| 30,1 | 301 | -990 | 49510 | 10,099 |
| 30,2 | 302 | -980 | 48530 | 10,098 |
| ... | | | | |
| 39,8 | 398 | -20 | 30 | 10,002 |
| 39,9 | 399 | -10 | 10 | 10,001 |
| 40,0 | 400 | 0 | 0 | 10,000 |
| 40,1 | 401 | 10 | 10 | 9,999 |
| 40,2 | 402 | 20 | 30 | 9,998 |
| ... | | | | |

Der Vollständigkeit halber sei angemerkt, daß die im betrachteten Beispiel durch ein spannungsgesteuertes Verzögerungsglied gebildete Phasenverschiebungseinrichtung nicht unbedingt durch ein Verzögerungsglied, und erst recht nicht durch ein spannungsgesteuertes Verzögerungsglied gebildet werden muß. Wichtig ist aber, daß es sich um eine Phasenverschiebungseinrichtung mit steuerbarer Phasenverschiebung handelt.

Es dürfte einleuchten und bedarf keiner näheren Erläuterung, daß durch die vorstehend beschriebene Taktsignalerzeugungseinrichtung auch andere Signale oder Signalverläufe als die vorstehend beispielhaft beschriebenen Signale oder Signalverläufe generiert werden können. Insbesondere besteht keine Einschränkung darauf,

- daß die Frequenz des Oszillatorsignals 10 MHz beträgt,
- daß eine dreieckförmige Modulation durchgeführt wird,
- daß der Modulationshub 100 kHz beträgt, und
- daß die Modulationsfrequenz 25 kHz beträgt.

Sämtliche Parameter können prinzipiell auch beliebig anders gewählt werden.

Die beschriebene Taktsignalerzeugungseinrichtung läßt sich unabhängig von den Einzelheiten der praktischen Realisierung einfacher und kleiner realisieren als es bei herkömmlichen Taktsignalerzeugungseinrichtungen der Fall ist, die als Spread Spectrum Oszillatoren einsetzbar sind. Insbesondere ist eine steuerbare Phasenverschiebungseinrichtung erheblich einfacher und kleiner realisierbar als ein zusätzlicher spannungsgesteuerter Oszillator.

Bezugszeichenliste

| CNT | Zähler |
| DAC | D/A-Wandler |
| DIV | Frequenzteiler |
| DIV2 | zweiter Frequenzteiler |
| INC | Inkrementierungseinrichtung, Adreßgenerierungseinrichtung |
| LF | Loop Filter |
| MEM | Speicher |
| OSC | Oszillator |
| OSCCLK | Ausgangssignal von OSC |
| PD | Phasenvergleicher |
| PLL | PLL |
| SUM | Summationsglied |
| V | Verzögerung |
| VCD | spannungsgesteuertes Verzögerungsglied |
| VCDCLK | Ausgangssignal von VCD |
| VCO | spannungsgesteuerter Oszillator |
| VCO2 | zweiter spannungsgesteuerter Oszillator |

**Patentansprüche**

1. Taktsignalerzeugungseinrichtung mit einem Oszillator (OSC) und einer diesem nachgeschalteten PLL (PLL), wobei zwischen dem Oszillator (OSC) und der PLL (PLL) eine Phasenverschiebungseinrichtung (VCD) vorgesehen ist, welche die Flanken des vom Oszillator (OSC) ausgegebenen Signals in zeitlich variierbarem Umfang verschieben kann, und das daraus resultierende Signal der PLL (PLL) als Eingangssignal zuführt,
**dadurch gekennzeichnet,**
daß die Steuersignale, unter Verwendung welcher die Phasenverschiebungseinrichtung (VCD) angesteuert wird, in einer Speichereinrichtung (MEM) gespeichert sind, und
daß die Speichereinrichtung (MEM) durch eine Adreßgenerierungseinrichtung (INC) adressiert wird, welche die jeweils zu verwendende Adresse unter Berücksichtigung des Ausgangssignals eines die Frequenz des Ausgangssignals des Oszillators (OSC) teilenden Frequenzteilers (DIV2) generiert.

2. Taktsignalerzeugungseinrichtung nach Anspruch 1,
**dadurch gekennzeichnet,**
daß die Phasenverschiebungseinrichtung (VCD) durch ein Verzögerungsglied mit einstellbarer Verzögerung gebildet wird.

3. Taktsignalerzeugungseinrichtung nach Anspruch 1 oder 2,
**dadurch gekennzeichnet,**
daß die Phasenverschiebungseinrichtung (VCD) durch ein spannungsgesteuertes Verzögerungsglied gebildet wird.

4. Taktsignalerzeugungseinrichtung nach einem der vorhergehenden Ansprüche,
**dadurch gekennzeichnet,**

daß die Speichereinrichtung (MEM) durch eine nichtflüchtige Speichereinrichtung gebildet wird.

5.  Taktsignalerzeugungseinrichtung nach einem der vorhergehenden Ansprüche,
    **dadurch gekennzeichnet,**
    daß das aus der Speichereinrichtung (MEM) ausgegebene Steuersignal der Phasenverschiebungseinrichtung (VCD) über einen D/A-Wandler zugeführt wird, welche den von der Speichereinrichtung (MEM) ausgegebenen Wert in ein analoges Steuersignal umwandelt.

6.  Taktsignalerzeugungseinrichtung nach einem der vorhergehenden Ansprüche,
    **dadurch gekennzeichnet,**
    daß die Phasenverschiebungseinrichtung (VCD) so angesteuert wird, daß die PLL (PLL) ein Taktsignal (SYSCLK) mit variierender Frequenz erzeugt.

7.  Taktsignalerzeugungseinrichtung nach einem der vorhergehenden Ansprüche,
    **dadurch gekennzeichnet,**
    daß die Phasenverschiebungseinrichtung (VCD) so angesteuert wird, daß die Taktsignalerzeugungseinrichtung als Spread Spectrum Oszillator verwendbar ist.

8.  Taktsignalerzeugungseinrichtung nach einem der vorhergehenden Ansprüche,
    **dadurch gekennzeichnet,**
    daß die Phasenverschiebungseinrichtung (VCD) so angesteuert wird, daß sie die Flanken des ihr vom Oszillator (OSC) zugeführten Taktsignals so verschiebt, daß das von der Phasenverschiebungseinrichtung (VCD) ausgegebene Taktsignal eine andere Frequenz aufweist als das vom Oszillator (OSC) ausgegebene Taktsignal.

**Claims**

1.  Clock signal generating device having an oscillator (OSC) and a PLL (PLL) connected downstream thereof, wherein there is provided between the oscillator (OSC) and the PLL (PLL) a phase shifting device (VCD), which can shift the edges of the signal output by the oscillator (OSC) to a temporally variable extent, and feeds the resultant signal to the PLL (PLL) as input signal,
    **characterized**
    in that the control signals which are used to drive the phase shifting device (VCD) are stored in a memory device (MEM), and
    in that the memory device (MEM) is addressed by an address generating device (INC), which generates the address that is respectively to be used whilst taking account of the output signal of a frequency divider (DIV2) which divides the frequency of the output signal of the oscillator (OSC).

2.  Clock signal generating device according to Claim 1,
    **characterized**
    in that the phase shifting device (VCD) is formed by a delay element with an adjustable delay.

3.  Clock signal generating device according to Claim 1 or 2,
    **characterized**
    in that the phase shifting device (VCD) is formed by a voltage-controlled delay element.

4.  Clock signal generating device according to one of the preceding claims,
    **characterized**
    in that the memory device (MEM) is formed by a nonvolatile memory device.

5.  Clock signal generating device according to one of the preceding claims,
    **characterized**
    in that the control signal output from the memory device (MEM) is fed to the phase shifting device (VCD) via a D/A converter, which converts the value output by the memory device (MEM) into an analog control signal.

6.  Clock signal generating device according to one of the preceding claims,
    **characterized**
    in that the phase shifting device (VCD) is driven in such a way that the PLL (PLL) generates a clock signal (SYSCLK) with a varying frequency.

7. Clock signal generating device according to one of the preceding claims, **characterized** in that the phase shifting device (VCD) is driven in such a way that the clock signal generating device can be used as a spread spectrum oscillator.

8. Clock signal generating device according to one of the preceding claims, **characterized** in that the phase shifting device (VCD) is driven in such a way that it shifts the edges of the clock signal fed to it from the oscillator (OSC) in such a way that the clock signal output by the phase shifting device (VCD) has a different frequency than the clock signal output by the oscillator (OSC).

**Revendications**

1. Dispositif générateur de signal d'horloge comportant un oscillateur (OSC) et une PLL (PLL) connectée en aval de celui-ci, dans lequel il est prévu entre l'oscillateur (OSC) et la PLL (PLL) un dispositif de déphasage (VCD) pouvant décaler les flancs du signal délivré par l'oscillateur (OSC) dans un intervalle variant temporellement, et qui achemine le signal qui en résulte à la PLL (PLL) en tant que signal d'entrée,
**caractérisé en ce que** les signaux de commande au moyen desquels le dispositif de déphasage (VCD) est commandé sont stockés dans un dispositif de mémoire (MEM), et
le dispositif de mémoire (MEM) est adressé par un dispositif générateur d'adresse (INC) qui génère l'adresse respective à utiliser sur la base du signal de sortie d'un diviseur de fréquence (DIV2) divisant la fréquence du signal de sortie de l'oscillateur (OSC).

2. Dispositif générateur de signal d'horloge selon la revendication 1, **caractérisé en ce que** le dispositif de déphasage (VCD) est constitué par un circuit à retard dont le retard est réglable.

3. Dispositif générateur de signal d'horloge selon la revendication 1 ou 2, **caractérisé en ce que** le dispositif de déphasage (VCD) est constitué par un circuit à retard commandé en tension.

4. Dispositif générateur de signal d'horloge selon l'une quelconque des revendications précédentes, **caractérisé en ce que** le dispositif de mémoire (MEM) est constitué par un dispositif de mémoire non volatil.

5. Dispositif générateur de signal d'horloge selon l'une quelconque des revendications précédentes, **caractérisé en ce que** le signal de commande délivré par le dispositif de mémoire (MEM) est acheminé au dispositif de déphasage (VCD) par l'intermédiaire d'un convertisseur D/A qui convertit la valeur délivrée par le dispositif de mémoire (MEM) en un signal de commande analogique.

6. Dispositif générateur de signal d'horloge selon l'une quelconque des revendications précédentes, **caractérisé en ce que** le dispositif de déphasage (VCD) est commandé de manière à ce que la PLL (PLL) génère un signal d'horloge (SYSCLK) de fréquence variable.

7. Dispositif générateur de signal d'horloge selon l'une quelconque des revendications précédentes, **caractérisé en ce que** le dispositif de déphasage (VCD) est commandé de manière à ce que le dispositif générateur de signal d'horloge puisse être utilisé en tant qu'oscillateur à étalement de spectre.

8. Dispositif générateur de signal d'horloge selon l'une quelconque des revendications précédentes, **caractérisé en ce que** le dispositif de déphasage (VCD) est commandé de manière à décaler les flancs du signal d'horloge qui lui est acheminé par l'oscillateur (OSC) de manière à ce que le signal d'horloge délivré par le dispositif de déphasage (VCD) présente une fréquence différente de celle du signal d'horloge délivré par l'oscillateur (OSC).

**FIG 1**

**FIG 2**

**FIG 3**

**FIG 4**

10,0 MHz                 OSCCLK

9,9 MHz                 VCDCLK

V[ns]

0,5 ns     1,0 ns     1,5 ns     2,0 ns

2,0
1,0

# FIG 5

f[MHz]

OSCCLK       VCDCLK

10.1
10.0
9.9

0    10µs    20µs    30µs    40µs    50µs    60µs   t

V[ns]

100
80
60
40
20
0

0    10µs    20µs    30µs    40µs    50µs    60µs   t

# FIG 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0655829 A1
- EP 0739089 A2
- WO 0021237 A1
- JP 2000101424 A

**In der Beschreibung aufgeführte Nicht-Patentliteratur**

- **KEITH B. et al.** Hardin et al: Spread Spectrum Clock Generation for the Reduction of Radiated Emissions. *IEEE International Symposium On Electromagnetic Compatibility,* 1994
- **KEITH B. HARDIN et al.** A Study of the Interference Potential of Spread Spectrum Clock Generation Techniques. *IEEE International Symposium On Electromagnetic Compatibility,* 1995
- **KEITH B. HARDIN et al.** Design Considerations of Phase-Locked Loop Systems for Spread Spectrum Clock Generation Compatibility. *IEEE International Symposium On Electromagnetic Compatibility,* 1997